# DEMANDE DE BREVET EUROPEEN

(11) **EP 0 539 262 A1**
(43) Date de publication de la demande: **28.04.1993**
(21) Numéro de dépôt: 92402770.9
(22) Date de dépôt: 09.10.1992
(51) Int. Cl.: H03H 7/01, H04K 3/00

(54) **Dispositif pour améliorer la cohabitation en présence de brouilleurs d'émetteurs-récepteurs radioélectriques avec un émetteur-récepteur agile en fréquence**

(30) Priorité: 22.10.1991 FR 9113012
(71) Demandeur: THOMSON-CSF, 75008 Paris (FR)
(72) Inventeur: Balin, Jean-Claude, F-92045 Paris La Défense (FR)
(74) Mandataire: Lincot, Georges

(57) **Abrégé**

Le dispositif est couplé entre une antenne d'émission-réception (3) et la sortie d'un émetteur-récepteur agile (4). Il comprend un réseau de filtres passe-bande (5, 6) composés chacun d'un filtre passe-bas en série avec un filtre passe-haut disposé en sortie d'un dispositif d'accouplement (2) pour accoupler l'émetteur-récepteur agile à son antenne d'émission-réception (3). Chacun des filtres passe-bas et passe-haut comporte au moins une self saturable (8, 13) commandée au rythme des changements de fréquence de l'émetteur-récepteur agile pour absorber l'énergie des brouilleurs arrivant sur l'antenne d'émission-réception (3) aux instants de commutation de fréquence de l'émetteur-récepteur agile (4).

Application : Radiocommunication.

## Description

La présente invention concerne un dispositif pour améliorer la cohabitation en présence de brouilleurs d'émetteurs-récepteurs radioélectriques avec un émetteur-récepteur agile en fréquence.

En effet, avec ce type de configuration, les signaux brouilleurs reçus par les antennes des émetteurs agiles sont modulés en phase par la réémission des niveaux de signaux des brouilleurs reçus sur les différentes antennes des émetteurs-récepteurs agiles et ceci a pour conséquence un élargissement du spectre des signaux brouilleurs qui nuit aux possibilités de cohabitation de ces émetteurs avec d'autres émetteurs-récepteurs à fréquence fixe placés à proximité. Il est connu pour remédier à cet inconvénient d'utiliser une commutation à pente douce des filtres d'accord d'antennes, Si le filtre est accordé par l'action d'une diode VARICAP cette procédure n'offre pas de difficultés réelles, par contre si le filtre est à poids capacitifs commutables par diodes PIN la pente douce est plus difficile à obtenir à cause de la loi résistive des diodes PIN. En effet, pour obtenir une commutation à pente douce dans ce dernier cas, la commande de la diode doit être faite approximativement suivant une loi exponentielle qui exige durant une part importante du temps de montée un courant faible dans la diode PIN. Des considérations identiques s'appliquent pour le temps de descente. Malgré ces dispositions et dans les deux cas l'efficacité de la commande en pente douce du circuit d'accord en présence d'un brouilleur puissant est malheureusement détruite par l'énergie du brouilleur qui vient perturber la mise en forme. Les résultats obtenus sont alors très décevants. D'autres procédés connus mettent en oeuvre un masque atténuateur devant le circuit d'accord agile mais comme la réalisation du masque met en oeuvre également des diodes PIN le défaut est déplacé et la perturbation provoquée par des brouilleurs puissants est toujours pénalisante. Il est connu également d'autres systèmes qui utilisent des filtrages par sous-gamme mais leur efficacité est au prix d'une diminution de la gamme de fréquences couvertes.

Le but de l'invention est de pallier les inconvénients précités.

A cet effet, l'invention a pour objet, un dispositif pour améliorer la cohabitation en présence de brouilleurs d'émetteurs-récepteurs radioélectriques avec un émetteur-récepteur agile en fréquence ledit dispositif étant couplé entre une antenne d'émission-réception et la sortie de l'émetteur-récepteur agile caractérisé en ce qu'il comprend un réseau de filtres passe-bande composés chacun d'un filtre passe-bas en série avec un filtre passe-haut disposé en sortie d'un dispositif d'accouplement pour accoupler l'émetteur-récepteur agile à son antenne d'émission-réception et en ce que chacun des filtres passe-bas et passe-haut comporte au moins une self saturable commandée au rythme des changements de fréquence de l'émetteur-récepteur agile pour absorber l'énergie des brouilleurs arrivant sur l'antenne d'émission-réception aux instants de commutation de fréquence de l'émetteur-récepteur agile.

D'autres caractéristiques et avantages de l'invention apparaîtront ci-après à l'aide de la description qui va suivre faite en regard des dessins annexés qui représentent :
- La figure 1 un premier mode de réalisation d'un dispositif selon l'invention ;
- La figure 2 un mode de réalisation d'un filtre composant le dispositif représenté à la figure 1 ;
- La figure 3 un mode de réalisation d'une self saturable mise en oeuvre dans le mode de réalisation du filtre de la figure 2 ;
- Les figures 4a et 4b des courbes d'atténuations des filtres du mode de réalisation de la figure 1 obtenues pour deux valeurs différentes de leurs selfs saturables ;
- Les figures 5a et 5b des diagrammes de temps montrant le fonctionnement du dispositif représenté à la figure 1 ;
- Les figures 6a et 6b des diagrammes de commutation en fréquence d' un émetteur-récepteur agile incorporant ou non un dispositif selon l'invention ;
- La figure 7 un deuxième mode de réalisation d'un dispositif selon l'invention.

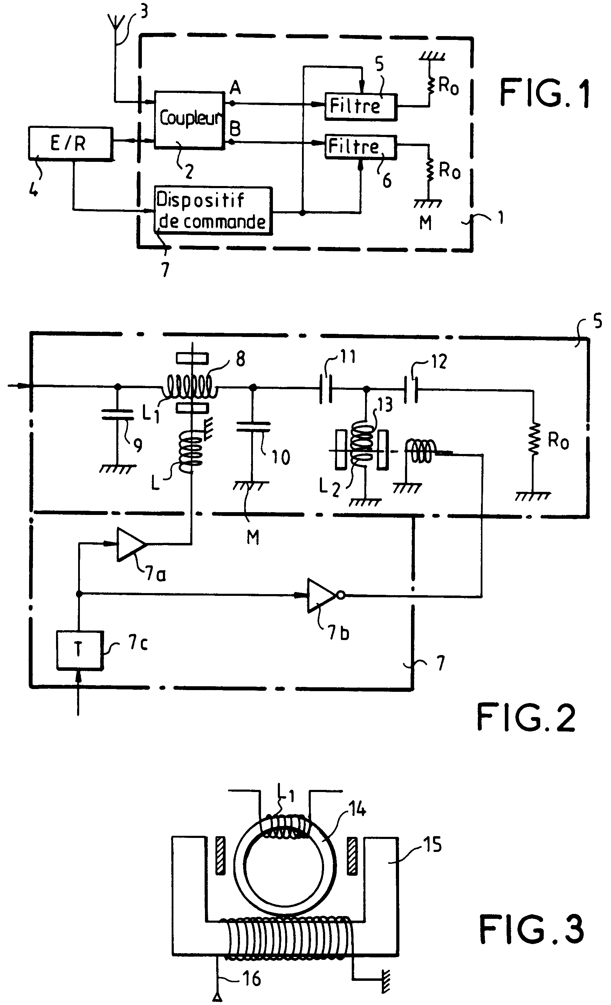

Pour permettre à des émetteurs agiles en fréquence de cohabiter avec des émetteurs à fréquence fixe placés à proximité les uns des autres le dispositif selon l'invention met en oeuvre un masque de type blanking à ferrite saturable dont la commande est entièrement découplée et indépendante de l'énergie des brouilleurs. Pour arriver à ce résultat chaque dispositif selon l'invention qui est référencé en 1 sur la figure 1 à l'intérieur d'une ligne fermée en pointillés, comporte un coupleur large bande 2 relié par une première porte d'entrée à une antenne d'émission-réception 3 d'un émetteur-récepteur agile 4 auquel il est connecté, une deuxième porte isolée reliée à la borne d'antenne de l'émetteur-récepteur 4 et deux portes de sortie A et B reliées respectivement à des réseaux de filtres passe-bande 5 et 6. Le réseau de filtres 5 qui est couplé à la sortie de la porte A possède une impédance caractéristique identique à celle de l'antenne 3 et du coupleur 2. Il est fermé sur sa sortie par une charge R₀ égale à leurs impédances caractéristiques. Le réseau constitué du filtre 6 a une structure identique à celle du réseau formé par le filtre 5 et sa charge est branchée sur la porte B du coupleur 2. L'antenne 3 est supposée du type large bande. Selon un premier mode de réalisation le coupleur 2 présente sur les portes A et B deux signaux déphasés l'un par rapport à l'autre de 90° et atténués de 3 dB par rapport au signal d'entrée. Selon un deuxième mode de réalisation le coupleur 2 est de type hybride et déphase les signaux en provenance de l'antenne 3 de 180° l'un par rapport à l'autre. Dans ce deuxième mode le réseau formé par le filtre 6 qui est couplé en sortie de la porte B du coupleur 2 doit être identique à celui qui est couplé à la porte A à la différence cependant qu'il doit être de type complémentaire, c'est-à-dire qu'il doit apporter un déphasage à 180° en dehors de sa bande passante par rapport au réseau formé par le filtre 5.

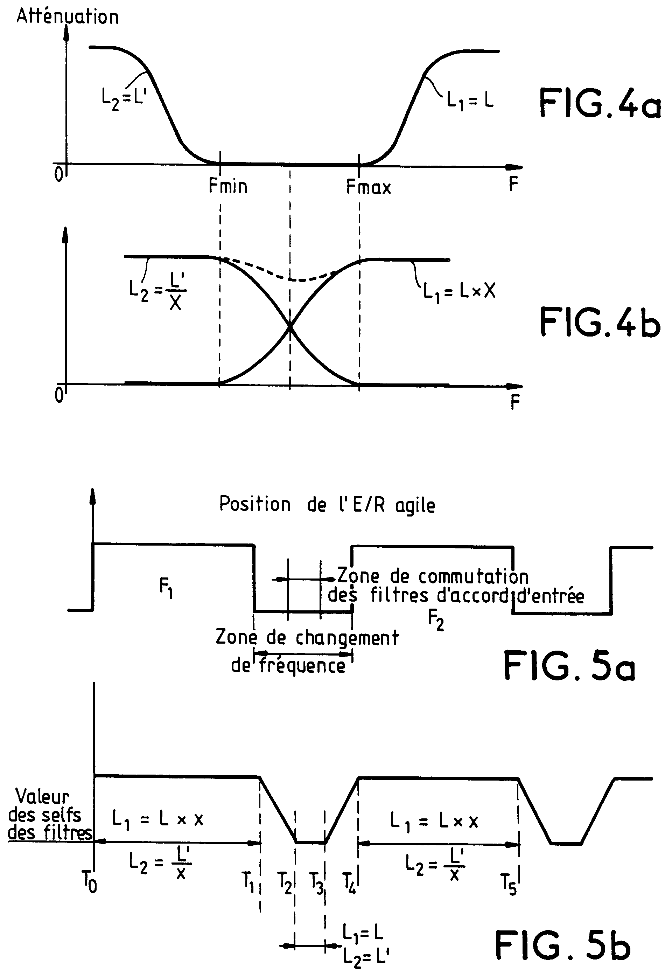

Un mode de réalisation d'un des filtres 5 ou 6 est représenté à la figure 2. Dans ce mode de réalisation le filtre possède une structure de filtre passe-bande formée d'un filtre passe-bas couplé à un filtre passe-haut. Le filtre passe-bas est formé par une cellule en ¶. Il comporte une self 8 dont les deux extrémités sont reliées à un circuit de masse M référençant les potentiels respectivement par l'intermédiaire de deux condensateurs 9 et 10. Le filtre passe-haut est formé par une cellule en T comportant deux condensateurs 11 et 12 reliés en série en sortie du filtre passe-bas et couplés par leur extrémité commune au circuit de masse M par l'intermédiaire d'une self 13. Pour permettre un accord des filtres 5 et 6 sur toute la bande de fréquence de fonctionnement de l'émetteur 4 les selfs 8 et 13 ont une structure de self saturable de type de celle qui est représentée à la figure 3. Sur la figure 3 le bobinage formant une self saturable est enroulé autour d'un noyau magnétique 14 formé éventuellement par un pot en ferrite polarisé par un champ magnétique fourni par un deuxième circuit magnétique 15 alimenté par une bobine d'induction 16. De la sorte, les valeurs d'inductance des selfs saturables 8 et 13 peuvent être réglées pour obtenir une atténuation des filtres 5 et 6 variant au rythme des changements de fréquence de l'émetteur agile 4. La commande est effectuée par le dispositif de commande 7 de la figure 1 formé sur la figure 2 par les amplificateurs 7ₐ et 7_{b} et par le basculeur 7_{c}. L'atténuation est minimale pendant les instants de changement des paliers de fréquence de l'émetteur-récepteur agile 4 et est maximale pendant la durée des paliers, comme le montre les figures 4a et 4b qui regroupent chacune sur un même graphique les courbes d'atténuation, fonction de la fréquence de fonctionnement de l'émetteur-récepteur agile 4, de chaque demi-filtre respectivement passe-bas et passe-haut composant les filtres 5 et 6. La figure 4a correspond à une configuration des filtres 5 et 6 pour laquelle l'atténuation est presque nulle durant les instants de changement des paliers de fréquence de l'émetteur-récepteur agile 4 à l'intérieur de sa bande de fréquence de fonctionnement limitée entre une fréquence maximum Fmax et une fréquence minimum Fmin. La figure 4b correspond par contre à une configuration où les filtres 5 et 6 présentent une atténuation non négligeable correspondant aux instants où l'émetteur-récepteur 4 émet ou reçoit sur ces paliers de fréquence. La courbe de la figure 4b est obtenue grâce à un chevauchement des courbes d'atténuation de chaque demi-filtre passe-bas et passe-haut composant chacun des filtres 5 et 6. En désignant par L₁ et L₂ les coefficients de self inductance des selfs saturables 8 et 13, par x le rapport entre les fréquences Fmax et Fmin, par L′ la valeur de l'inductance 13 et par L la valeur de l'inductance 8 correspondant aux courbes d'atténuation de la figure 4a, les courbes d'atténuation de la figure 4b se déduisent de celles de la figure 4a en réglant la valeur de l'inductance 13 à la valeur L′/x et la valeur de l'inductance 8 à une valeur L₁ = L.x.

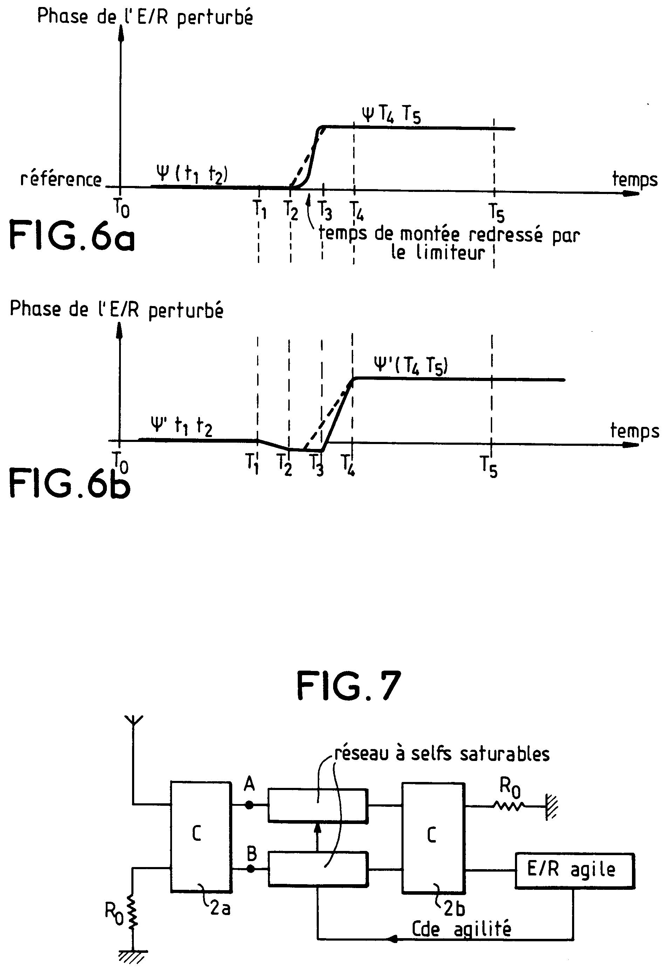

Une illustration de ce mode de fonctionnement est montrée sur le graphe de la figure 5 entre des instants t₀ à t₅ illustrant des phases de fonctionnement d'un émetteur-récepteur agile sur deux paliers de fréquence différents. Dans cet exemple l'émetteur-récepteur agile 4 est supposé en fonctionnement sur une fréquence F₁ entre les instants t₀ à t₁. Sur ce palier de fréquence la valeur des selfs 8 des filtres 5 et 6 est multipliée par le facteur x et la valeur des selfs 13 est divisée par ce même facteur ce qui donne pour les filtres 5 et 6 une courbe d'atténuation conforme à la figure 4b. L'énergie en provenance de l'émetteur-récepteur agile 4 est quant à elle divisée en deux parties égales et entièrement réfléchie sur les portes A et B alimentant les filtres 5 et 6. Ces deux énergies réfléchies se retrouvent intégralement en phase sur la porte d'entrée reliée à l'antenne 3. Durant ce temps l'énergie d'un brouilleur fort présente sur l'antenne est divisée en deux parties égales et est entièrement réfléchies sur les portes A et B. Ces deux énergies réfléchies se retrouvent intégralement en phase sur la porte isolée à l'entrée du circuit d'accord de l'émetteur-récepteur agile 4. Comme d'une façon générale la fréquence d'un brouilleur peut toujours être supposée différente de la fréquence F₁ cette énergie est elle aussi de nouveau réfléchie sur les portes A et B pour se retrouver sur la porte d'entrée du coupleur 2 et être par conséquent réémise par l'antenne 3, en venant ainsi perturber les émetteurs -récepteurs à fréquence fixe placés à proximité. Entre les instants t₂ et t₃ l'émetteur-récepteur agile est en période morte de changement de fréquence et dans ce cas les filtres 5 et 6 sont placés dans la configuration correspondante de la figure 4a. L'émetteur-récepteur agile 4 commute alors son circuit d'accord d'entrée et l'énergie résiduelle qui durant cette phase peut être émise notamment dans les circuits d'accord à capacité commutable, se trouve être entièrement absorbée dans les résistances R₀ de fermeture des filtres 5 et 6. Cette énergie n'est donc pas réémise par l'antenne 3 entre les instants t₂ et t₃. De la sorte, la cohabitation avec l'émetteur-récepteur durant l'intervalle de temps t₃ -t₂ à fréquence fixe n'est pas perturbée. Le brouilleur qui est toujours présent sur l'antenne 3 est également entièrement absorbé dans les résistances R₀ de fermeture des filtres 5 et 6 et n'est pas non plus réémise par l'antenne 3. L'avantage obtenu au niveau de l'émetteur-récepteur à fréquence fixe placé à proximité est mis en évidence par les graphes des figures 6a et 6b. En l'absence du dispositif selon l'invention il apparaît sur la figure 6a, qu'entre les instants t₁ et t₂ lorsqu'il y a baisse progressive de la puissance de l'émetteur-récepteur agile 4 que la phase (t₀,t₂) de l'émetteur-récepteur à fréquence fixe placé à proximité est la combinaison vectorielle du signal en provenance directe du brouilleur et de la réflexion totale du signal brouilleur sur l'aérien de l'antenne de l'émetteur-récepteur agile 4, Entre les instants t₀ et t₂ cette phase (t₀,t₂) reste constante. Si la commutation du circuit d'accord de l'émetteur-récepteur agile est parfaite la phase du signal brouilleur sur l'émetteur-récepteur à fréquence fixe placé à proximité doit évoluer suivant la courbe en pointillés montrée à la figure 6a puisque la combinaison vectorielle dans ce cas est modifiée. Mais comme l'énergie du brouilleur contrarie en fait cette commande, la courbe réelle obtenue est celle en traits pleins figurée entre les instants t₂ et t₃ de la figure 6a. Entre les instants t₄ et t₅ la phase (t₄,t₅) reste de nouveau constante. Grâce au dispositif selon l'invention dès l'instant t₁ et jusqu'à l'instant t₂ la saturation de la self 8 s'opère tandis que la self 13 est désaturée. Pendant cette période de temps, la commande des selfs 8 et 13 n'a aucune incidence sur l'émetteur-récepteur agile 4 et coupe juste sa puissance du fait que la commande a lieu simultanément sur les portes A et B. Les coefficients de réflexion sur les portes A et B sont alors identiques et le coefficient de réflexion vu par l'émetteur-récepteur agile est alors nul. Entre les instants t₂ et t₃ a lieu la commutation par l'émetteur-récepteur agile 4 les valeurs des selfs 8 et 13 qui atteignent respectivement les valeurs L et L'. Entre ces instants l'énergie du brouilleur est entièrement absorbée par les charges R₀ des filtres 5 et 6 et la variation de phase suit la courbe représentée à la figure 6B. Comme précédemment la phase est constante entre les instants t₀ et t₁, elle subit une variation en pente douce entre les instants t₁ et t₂ qui correspond à la suppression de la composante réfléchie du brouilleur sur l'antenne de l'émetteur-récepteur agile 4. Entre les instants t₂ et t₃ la phase reste constante puis entre t₃ et t₄ la désaturation de la self 8 et la saturation de la self 13 ont lieu en pente douce sans être perturbées par le brouilleur pour atteindre une valeur déterminée qui reste constante entre les instants t₄ et t₅. Les sauts de phase ainsi obtenus ont de la sorte une pente moins raide ce qui permet d'assurer une meilleure cohabitation avec les émetteurs-récepteurs à fréquence fixe placés à proximité. Une légère amélioration de la pente du saut de phase peut encore être obtenue en commandant la désaturation de la self après l'instant t₂ à un instant t₂+(t₃-t₂)/2 au lieu de commencer cette désaturation à l'instant t₃ comme le montre la courbe en pointillés sur la figure 6b.

Naturellement l'invention n'est pas limitée à l'exemple décrit et il va de soi que d'autres modes de réalisation restent envisageables, en adaptant par exemple de manières différentes le réseau de filtres 5 et 6 à l'antenne d'émission réception 3, d'une part, et à l'émetteur-récepteur 4, d'autre part. Ainsi comme le montre la figure 7 ce couplage peut aussi être réalisé à l'aide de deux coupleurs en quadrature ou hybrides disposés de part et d'autre du réseau de filtres 5 et 6, l'un étant couplé à l'antenne 3 et l'autre à l'émetteur-récepteur 4.

Dans ce cas le fonctionnement en saturation ou désaturation des selfs doit être inversé par rapport au fonctionnement obtenu avec un dispositif à un seul coupleur tel qu'il est représenté à la figure 1.

Egalement, le mode de réalisation des selfs saturables peut-être différent de celui de la figure 3 et peut éventuellement consister à enrouler les selfs saturables sur un même tore ou un même barreau en ferrite.

## Revendications

1. Dispositif pour améliorer la cohabitation en présence de brouilleurs d'émetteurs-récepteurs radioélectriques avec un émetteur-récepteur agile en fréquence ledit dispositif étant couplé entre une antenne d'émission-réception (3) et la sortie de l'émetteur-récepteur agile (4) caractérisé en ce qu'il comprend un réseau de filtres passe-bande (5, 6) composés chacun d'un filtre passe-bas en série avec un filtre passe-haut disposé en sortie d'un dispositif d'accouplement (2) pour accoupler l'émetteur-récepteur agile à son antenne d'émission-réception (3) et en ce que chacun des filtres passe-bas et passe-haut comporte au moins une self saturable (8, 13) commandée au rythme des changements de fréquence de l'émetteur-récepteur agile pour absorber l'énergie des brouilleurs arrivant sur l'antenne d'émission-réception (3) aux instants de commutation de fréquence de l'émetteur-récepteur agile (4).

2. Dispositif selon la revendication 1 caractérisé en ce que le dispositif d'accouplement (2) applique sur le réseau de filtres (5, 6) deux signaux en quadrature l'un par rapport à l'autre et atténués de 3 dB par rapport au signal fourni par l'antenne d'émission-réception (3).

3. Dispositif selon la revendication 1 caractérisé en ce que le dispositif d'accouplement (2) est un coupleur hybride (2) appliquant sur le réseau de filtres (5, 6) deux signaux déphasés de 180° l'un par rapport à l'autre.

4. Dispositif selon l'une quelconque des revendications 1 à 3 caractérisé en ce que chaque self saturable (8, 13) comprend une bobine enroulée autour d'un noyau magnétique (14) et un circuit magnétique (15) alimenté par une bobine d'inductance (16) pour saturer magnétiquement le noyau magnétique (14) par un champ magnétique variable formé par la bobine d'inductance (16).

5. Dispositif selon la revendication 4 caractérisé en ce que les selfs saturables sont bobinées autour de pots en ferrite.

6. Dispositif selon la revendication 4 caractérisé en ce que les selfs saturables sont bobinées sur un tore en ferrite.

7. Dispositif selon la revendication 4 caractérisé en ce que les selfs saturables sont bobinées sur un barreau en ferrite.

8. Dispositif selon la revendication 1 caractérisé en ce que le dispositif d'accouplement (2) comporte deux coupleurs (2ₐ, 2_{b}) en quadrature ou hybrides disposés de part et d'autre du réseau de filtres (5, 6), un premier coupleur (2ₐ) étant relié à l'antenne d'émission, le deuxième coupleur (2_{b}) étant relié à l'émetteur-récepteur agile (4).
